# EUROPEAN PATENT APPLICATION

(11) **EP 4 514 090 A1**
(43) Date of publication of application: **26.02.2025**
(21) Application number: 24165058.9
(22) Date of filing: 21.03.2024
(51) Int. Cl.: H10B 12/00

(54) **SEMICONDUCTOR DEVICE AND METHOD OF FABRICATING THE SAME**

(30) Priority: 25.08.2023 KR 20230111731
(71) Applicant: Samsung Electronics Co., Ltd., Suwon-si, Gyeonggi-do 16677 (KR)
(72) Inventor: PARK, Kyungwook, 16677 Suwon-si, Gyeonggi-do (KR); KANG, Sangmin, 16677 Suwon-si, Gyeonggi-do (KR); SEO, Changwoo, 16677 Suwon-si, Gyeonggi-do (KR); SONG, Suyoun, 16677 Suwon-si, Gyeonggi-do (KR); LEE, Dain, 16677 Suwon-si, Gyeonggi-do (KR)
(74) Representative: Kuhnen & Wacker Patent- und Rechtsanwaltsbüro PartG mbB

(57) **Abstract**

A semiconductor device may include first and second active patterns, each including a center portion and an edge portion, the center portion of the first active pattern and the edge portion of the second active pattern adjacent to each other, a device isolation pattern between the first and second active patterns, a bit line node contact on the center portion of the first active pattern, a bit line on the bit line node contact, a storage node contact on the edge portion of the second active pattern, a bit line spacer between the bit line and the storage node contact, and a gapfill insulating pattern between a lower portion of the bit line spacer and the storage node contact. The center portion of the first active pattern may include a center oxide region in an upper portion thereof.

## Description

### CROSS-REFERENCE TO RELATED APPLICATIONS

This U.S. non-provisional patent application claims priority under 35 U.S.C. §119 to Korean Patent Application No. 10-2023-0111731, filed on August 25, 2023, in the Korean Intellectual Property Office, the entire contents of which are hereby incorporated by reference.

### BACKGROUND

Various example embodiments relate to a semiconductor device, and in particular, to a semiconductor device and/or a method of fabricating the same.

Due to their small-sized, multifunctional, and/or low-cost characteristics, semiconductor devices are being esteemed as important elements in the electronics industry. The semiconductor devices may be classified into a memory device for storing data, a logic device for processing data, and a hybrid device including both of memory and logic elements.

Due to the recent increasing demand for electronic devices with a fast speed and/or low power consumption, the semiconductor device requires a fast operating speed and/or a low operating voltage. To meet or help to meet such requirements, the integration density of semiconductor devices is being increased, and many research studies are being conducted.

### SUMMARY

Various example embodiments provide a semiconductor device, which can be fabricated with a low failure rate and/or an improved yield, and/or a method of fabricating the same.

Alternatively or additionally, various example embodiments may provide a semiconductor device with improved electrical and/or reliability characteristics, and/or a method of fabricating the same.

According to some example embodiments, a semiconductor device may include first and second active patterns, each of which includes a center portion and an edge portion, the center portion of the first active pattern and the edge portion of the second active pattern adjacent to each other, a device isolation pattern between the first and second active patterns, a bit line node contact on the center portion of the first active pattern, a bit line on the bit line node contact, a storage node contact on the edge portion of the second active pattern, a bit line spacer between the bit line and the storage node contact, and a gapfill insulating pattern between a lower portion of the bit line spacer and the storage node contact. The center portion of the first active pattern may include a center oxide region in an upper portion thereof.

Alternatively or additionally according to various example embodiments, a semiconductor device may include a first active pattern and a second active pattern adjacent to each other, a device isolation pattern between the first and second active patterns, a recess region defined by the first active pattern and the device isolation pattern, a bit line node contact on the first active pattern, a gapfill insulating pattern provided on a side surface of the bit line node contact to fill the recess region, a bit line spacer between the side surface of the bit line node contact and the gapfill insulating pattern, and an intermediate material between the gapfill insulating pattern and the device isolation pattern. The intermediate material may include at least one of a halogen element and carbon.

Alternatively or additionally according to various example embodiments, a semiconductor device may include first and second active patterns, each including a center portion and an edge portion, the center portion of the first active pattern and the edge portion of the second active pattern adjacent to each other, a device isolation pattern between the first and second active patterns, a bit line node contact on the center portion of the first active pattern, a bit line on the bit line node contact, a gapfill insulating pattern on a side surface of the bit line node contact, and a bit line spacer covering a side surface of the bit line and extending to a region between the side surface of the bit line node contact and the gapfill insulating pattern. The gapfill insulating pattern may be in contact with the device isolation pattern and may vertically and partially overlap the edge portion of the second active pattern.

Alternatively or additionally according to various example embodiments, a method of fabricating a semiconductor device may include forming a recess region on a center portion of a first active pattern and an edge portion of a second active pattern the first and second active patterns adjacent to each other, the recess region exposing a portion of the edge portion of the second active pattern, forming a bit line node contact on the center portion of the first active pattern, forming a bit line on the bit line node contact, oxidizing the exposed portion of the edge portion of the second active pattern to form an edge oxide region, selectively forming a sub-spacer on a side surface of the bit line node contact and a side surface of the bit line, and forming a gapfill insulating pattern to fill the recess region.

### BRIEF DESCRIPTION OF THE DRAWINGS

FIG. 1 is a plan view illustrating a semiconductor device according to various example embodiments
FIGS. 2A and 2B are sectional views taken along lines A-A' and B-B', respectively, of FIG. 1.
FIG. 3 is an enlarged sectional view corresponding to a portion P1 of FIG. 2A.
FIGS. 4 to 6 are sectional views taken along the line A-A' of FIG. 1.
FIGS. 7 to 22 are diagrams illustrating a method of fabricating a semiconductor device, according to various example embodiments
FIGS. 23 and 24 are sectional views illustrating a method of fabricating a semiconductor device, according to various example embodiments
FIGS. 25 and 26 are flow charts illustrating a method of fabricating a first sub-spacer.

### DETAILED DESCRIPTION

Various example features and embodiments will now be described more fully with reference to the accompanying drawings, in which example embodiments are shown.

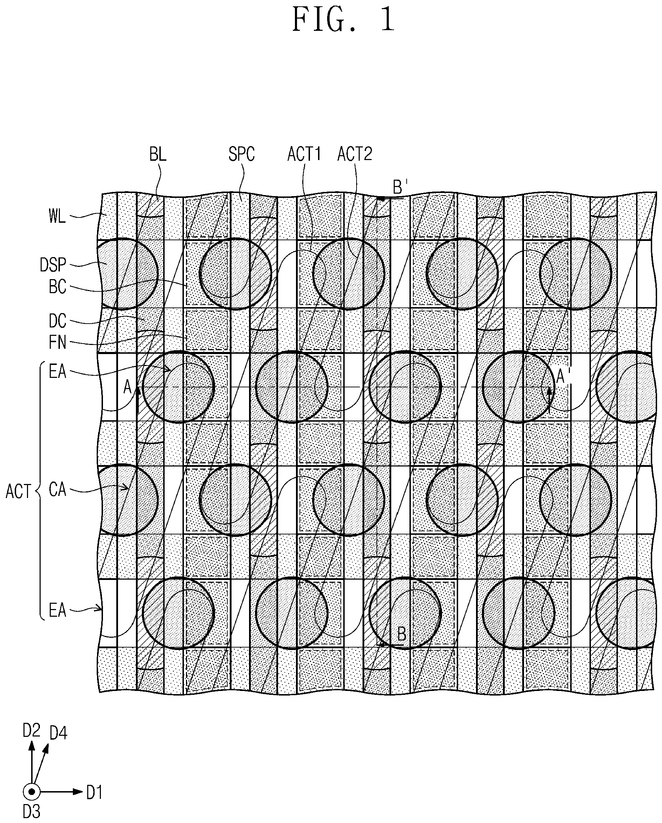

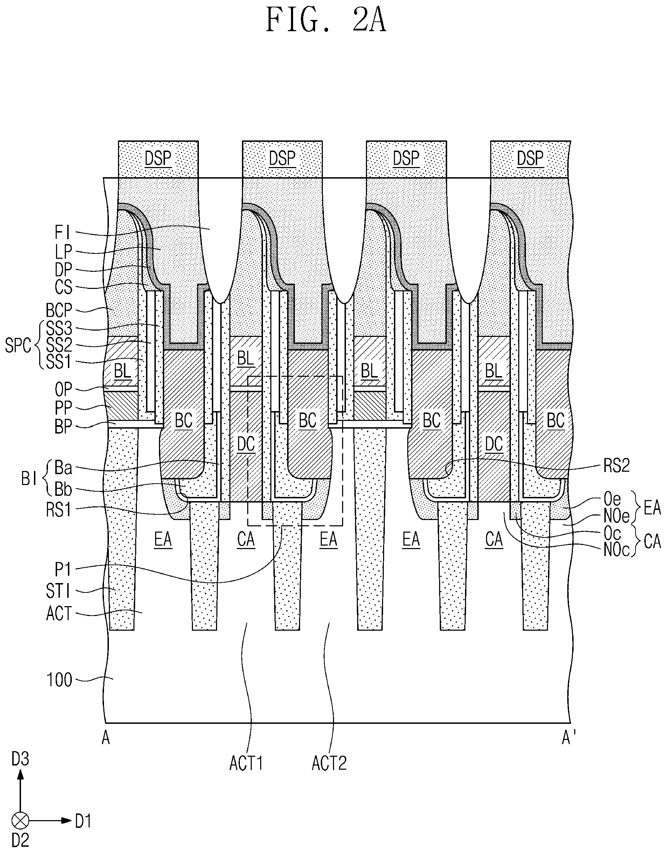

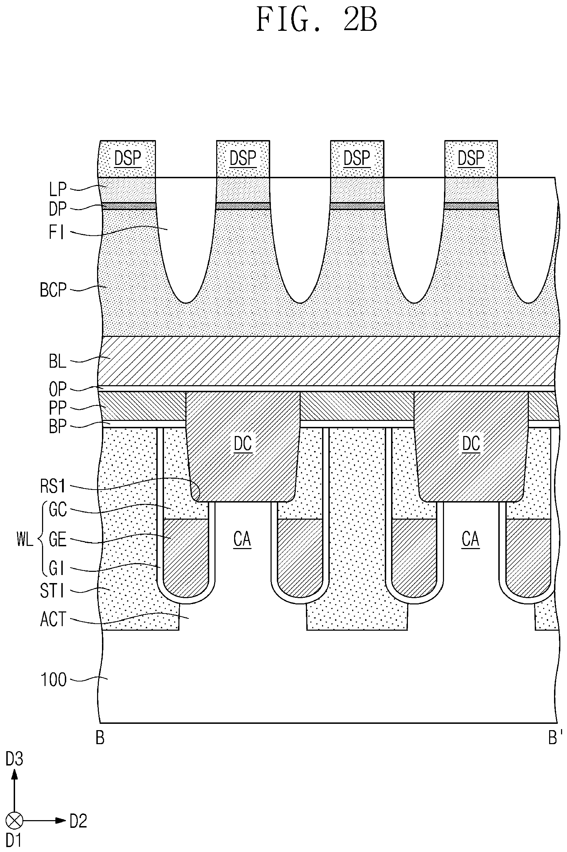

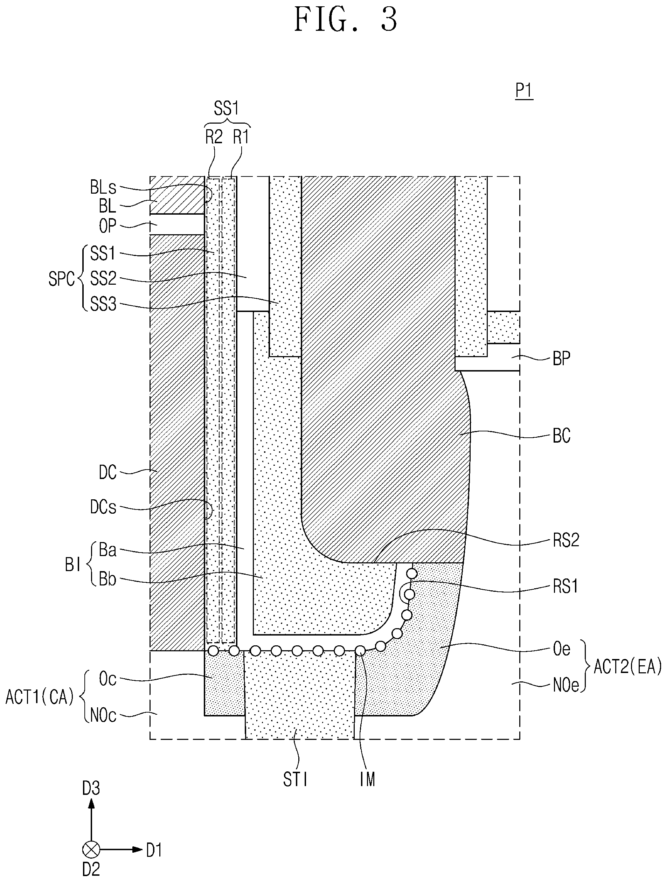

FIG. 1 is a plan view illustrating a semiconductor device according to various example embodiments FIGS. 2A and 2B are sectional views taken along lines A-A' and B-B', respectively, of FIG. 1. FIG. 3 is an enlarged sectional view corresponding to a portion P1 of FIG. 2A.

Referring to FIGS. 1 to 3, a substrate 100 may be provided. The substrate 100 may be or may include, or may be included in, for example, one or more of a silicon substrate, a germanium substrate, or a silicon-germanium substrate.

A device isolation pattern STI may be disposed on the substrate 100. The device isolation pattern STI may define active patterns ACT in the substrate 100. Each of the active patterns ACT may include a center portion CA, which is provided between a pair of word lines WL to be described below, and a pair of edge portions EA, which hare spaced apart from each other with the center portion CA interposed therebetween. The paired edge portions EA may be opposite end portions of the active pattern ACT. The center portion CA and the paired edge portions EA may include impurity regions that are doped with impurities (e.g., n-type and/or p-type impurities).

The active patterns ACT may be adjacent to each other in a first direction D1 and a second direction D2, which are parallel to a bottom surface of the substrate 100 and are not parallel to each other, and, in some example embodiments may be orthogonal to each other. As described herein, the expression "the paired active patterns ACT are adjacent to each other in the first direction D1" may indicate that the center portion CA of one of the paired active patterns ACT is adjacent to the edge portion EA of the other in the first direction D1. As shown in FIG. 1, a first active pattern ACT1 and a second active pattern ACT2 may be adjacent to each other in the first direction D1. As described herein, the expression "the paired active patterns ACT are adjacent to each other in the second direction D2" may indicate that the center portions CA of the paired active patterns ACT are adj acent to each other in the second direction D2.

Each of the active patterns ACT may have a shape protruding in a third direction D3 perpendicular to the bottom surface of the substrate 100. In some example embodiments, the device isolation pattern STI may be disposed in or at least partially in the substrate 100, and the active patterns ACT may be or may include or be included in portions of the substrate 100, which are enclosed by the device isolation pattern STI. For the sake of convenience in explanation, the term "substrate 100" may refer to the remaining portion of the substrate 100, excluding the active patterns ACT, unless otherwise stated or clear from context.

The active patterns ACT may be isolated bar-shaped patterns, which are spaced apart from each other and are elongated in a fourth direction D4. The fourth direction D4 may be parallel to the bottom surface of the substrate 100 and may not be parallel to the first and second directions D1 and D2. The fourth direction may form an angle, such as an acute angle, with either or both of the first and second directions D1 and D2. The paired edge portions EA of the active pattern ACT may be spaced apart from each other in the fourth direction D4, with the center portion CA interposed therebetween.

The center portion CA of the active pattern ACT may include a center oxide region Oc and a center non-oxide region NOc, and the edge portion EA may include an edge oxide region Oe and an edge non-oxide region NOe. The center oxide region Oc may be or may include or be included in an oxidized region of the center portion CA, and the center non-oxide region Noc may be or may include or be included in an un-oxidized region of the center portion CA. The edge oxide region Oe may be or may include or be included in an oxidized region of the edge portion EA, and the edge non-oxide region NOe may be or may include or be included in an un-oxidized region of the edge portion EA. The center and edge oxide regions Oc and Oe may be provided adjacent to a first recess region RS1, which will be described below.

The center oxide region Oc may be provided on the center portion CA of the active pattern ACT. Each center portion CA may include a pair of center oxide regions Oc, which are spaced apart from each other in the first direction D1. When viewed in a plan view, the pair of center oxide regions Oc may be provided at both sides of a bit line node contact DC, which will be described below.

The device isolation pattern STI may include an insulating material. As an example, the device isolation pattern STI may be formed of or include at least one of silicon oxide or silicon nitride. The device isolation pattern STI may be a single layer, which is made of one of the above materials, or a composite layer, which is made of at least two of the above materials. The device isolation pattern STI may include or be formed with a shallow trench isolation process; example embodiments are not limited thereto.

The word line WL may be disposed to cross the active patterns ACT. As an example, the word line WL may cross the active patterns ACT and the device isolation pattern STI in the first direction D1. In some example embodiments, a plurality of word lines WL may be provided. The word lines WL may be spaced apart from each other in the second direction D2. In some example embodiments, a pair of the word lines WL, which are adj acent to each other in the second direction D2, may be provided to cross the active pattern ACT.

In some example embodiments, each of the word lines WL may include a gate electrode GE, a gate insulating pattern GI, and a gate capping pattern GC. The gate electrode GE may be provided to cross the active patterns ACT and the device isolation pattern STI in the first direction D1. The gate insulating pattern GI may be interposed between the gate electrode GE and the active patterns ACT. The gate capping pattern GC may cover a top surface of the gate electrode GE.

A buffer pattern BP may be disposed on the substrate 100. The buffer pattern BP may cover the active patterns ACT, the device isolation pattern STI, and the word lines WL. The buffer pattern BP may be formed of or include at least one of silicon oxide, silicon nitride, or silicon oxynitride. The buffer pattern BP may be a single layer, which is made of a single material, or a composite layer including two or more materials.

The bit line node contact DC may be provided on each of the active patterns ACT, and in some example embodiments, a plurality of bit line node contacts DC may be provided. The bit line node contacts DC may be provided on and electrically connected to the center portions CA of the active patterns ACT, respectively. The bit line node contacts DC may be spaced apart from each other in the first and second directions D1 and D2. The bit line node contacts DC may be interposed between the active patterns ACT and bit lines BL, which will be described below. Each of the bit line node contacts DC may electrically connect a corresponding one of the bit lines BL to the center portion CA of a corresponding one of the active patterns ACT. In some example embodiments, the bit line node contact DC may be formed of or may include doped polysilicon; example embodiments are not limited thereto.

The bit line node contacts DC may be disposed in the first recess regions RS1, respectively. The first recess regions RS1 may be provided in upper portions of the active patterns ACT and an upper portion of the device isolation pattern STI, which is adjacent to the upper portions of the active patterns ACT. In some example embodiments, the first recess region RS1 may be defined by the active pattern ACT and the device isolation pattern STI.

The bit line BL may be provided on the bit line node contact DC. The bit line BL may be disposed on the bit line node contacts DC, which are linearly arranged in the second direction D2. In some example embodiments, a plurality of bit lines BL may be provided. The bit lines BL may be spaced apart from each other in the first direction D1. The bit line BL may include a metallic material. The bit line BL may be formed of or include at least one of metallic materials (e.g., Ti, Mo, W, Cu, Al, Ta, Ru, Ir, Co, Pt, Au, and Ag).

A polysilicon pattern PP may be interposed between the bit line BL and the buffer pattern BP. A top surface of the polysilicon pattern PP may be located at substantially the same height as a top surface of the bit line node contact DC. The polysilicon pattern PP may be formed of or include doped polysilicon.

An ohmic pattern OP may be interposed between the bit line BL and the bit line node contact DC and between the bit line BL and the polysilicon pattern PP. The ohmic pattern OP may be formed of or include at least one of metal silicide materials (e.g., silicide materials containing one or more of Ti, Mo, W, Cu, Al, Ta, Ru, Ir, Co, Pt, Au, and Ag). A barrier pattern (not shown) may be further interposed between the bit line BL and the bit line node contact DC and between the bit line BL and the polysilicon pattern PP. The barrier pattern may be formed of or include at least one of conductive metal nitride materials (e.g., nitride materials containing one or more of Ti, Mo, W, Cu, Al, Ta, Ru, Ir, Co, Pt, Au, and Ag).

A bit line capping pattern BCP may be provided on the bit line BL. In various example embodiments, the bit line capping patterns BCP may be provided on the top surfaces of the bit lines BL, respectively. The bit line capping patterns BCP may extend along the corresponding bit lines BL and in the second direction D2 and may be spaced apart from each other in the first direction D1. Each of the bit line capping patterns BCP may be vertically overlapped with a corresponding one of the bit lines BL. The bit line capping pattern BCP may be composed of a single layer or a plurality of layers. In some example embodiments, the bit line capping pattern BCP may include a first capping pattern (not shown), a second capping pattern (not shown), and a third capping pattern (not shown) sequentially stacked. In some example embodiments, each of the first to third capping patterns may be formed of or include silicon nitride. As another example, the bit line capping pattern BCP may further include additional capping patterns (e.g., fourth and fifth capping patterns (not shown)).

A gapfill insulating pattern BI may fill each of the first recess regions RS1. The gapfill insulating pattern BI may fill an inner space of the first recess region RS1. In various example embodiments, the gapfill insulating pattern BI may cover or at least partially Cover an inner surface of the first recess region RS1 and a side surface DCs of the bit line node contact DC. In the first recess region RS1, the gapfill insulating pattern BI may be in contact with the device isolation pattern STI. The gapfill insulating pattern BI may be vertically overlapped with the center and edge portions CA and EA of the active pattern ACT. The gapfill insulating pattern BI may be vertically overlapped with a portion of the edge portion EA of the active pattern ACT. In the first recess region RS1, the gapfill insulating pattern BI may be in further contact with the edge portion EA of the active pattern ACT.

The gapfill insulating pattern BI may include an outer gapfill pattern Ba, which conformally covers the inner surface of the first recess region RS1, and an inner gapfill pattern Bb, which is provided on the outer gapfill pattern Ba to fill the first recess region RS1. The outer gapfill pattern Ba may be in contact with a first sub-spacer SS1, which will be described below, and the device isolation pattern STI. In some example embodiments, the outer gapfill pattern Ba may be in further contact with the center and edge oxide regions Oc and Oe.

The outer gapfill pattern Ba may contain oxygen and in some example embodiments may or may not include nitrogen. The inner gapfill pattern Bb may contain nitrogen and in some example embodiments may or may not include oxygen. As an example, the outer gapfill pattern Ba may be formed of or include SiO2, and the inner gapfill pattern Bb may be formed of or include SiN.

A bit line spacer SPC may be provided on a side surface DCs of the bit line node contact DC, a side surface BLs of the bit line BL, and a side surface of the bit line capping pattern BCP. The bit line spacer SPC may cover the side surface DCs of the bit line node contact DC, the side surface BLs of the bit line BL, and the side surface of the bit line capping pattern BCP. The bit line spacer SPC may extend along the side surface BLs of the bit line BL and in the second direction D2. The bit line spacer SPC may be interposed between the bit line BL and a storage node contact BC to be described below and may separate them from each other. The lowermost surface of the bit line spacer SPC (e.g., the lowermost surface of a first sub-spacer SS1 to be described below) may be substantially coplanar with a bottom surface of the gapfill insulating pattern BI.

The bit line spacer SPC may include a plurality of sub-spacers. In some example embodiments, each of the bit line spacers SPC may include a first sub-spacer SS1, a second sub-spacer SS2, and a third sub-spacer SS3, which are sequentially provided on the side surface BLs of the bit line BL. Each of the first to third sub-spacers SS1, SS2, and SS3 may be formed of or include at least one of SiN, SiON, SiOCN, or SiOCH. In some example embodiments, at least a portion of the first to third sub-spacers SS1, SS2, and SS3 may include an empty space (e.g., an air gap) with an air layer such as a clean, dry air layer that may or may not be in vacuum.

The first sub-spacer SS1 may cover the side surface DCs of the bit line node contact DC, the side surface BLs of the bit line BL, and the side surface of the bit line capping pattern BCP and may continuously extend toward an inner bottom surface of the first recess region RS1 along the side surfaces. The first sub-spacer SS1 may extend into a region between the gapfill insulating pattern BI and the side surface DCs of the bit line node contact DC. The first sub-spacer SS1 may separate the gapfill insulating pattern BI from the bit line node contact DC.

The first sub-spacer SS1 may not extend to the inner surface of the first recess region RS1. The first sub-spacer SS1 may be spaced apart from the storage node contact BC, which will be described below. In some example embodiments, a lower portion of the first sub-spacer SS1 may be spaced apart from the storage node contact BC. The first sub-spacer SS1 may not be interposed between the gapfill insulating pattern BI and the device isolation pattern STI (e.g., between the outer gapfill pattern Ba and the device isolation pattern STI) and may not extend to a region on the device isolation pattern STI. The first sub-spacer SS1 may separate the second sub-spacer SS2 from the side surface BLs of the bit line BL.

The first sub-spacer SS1 may include a first region R1, which is adjacent to the second sub-spacer SS2, and a second region R2, which is provided between the first region R1 and the bit line BL. The second region R2 may separate the first region R1 from the bit line BL and the bit line node contact DC. Each of the first and second regions R1 and R2 may include nitrogen. The first region R1 may include oxygen, and the second region R2 may not include oxygen. As an example, the first and second regions R1 and R2 may be formed of or include SiON and SiN, respectively, but example embodiments are not limited thereto. The oxygen in the first region R1 may result from the diffusion from the second sub-spacer SS2 or the outer gapfill pattern Ba. In some example embodiments, the second sub-spacer SS2 may contain the oxygen or may be formed using an oxygen-containing material, even when its final structure does not contain the oxygen. As an example, the second sub-spacer SS2 may be formed of or include SiO2. In some example embodiments, the second sub-spacer SS2 may be an air gap between the first and third sub-spacers SS1 and SS3. In some example embodiments, the third sub-spacer SS3 may be formed of or include a nitrogen-containing material (e.g., SiN).

If the bit line node contact DC is adjacent to the oxygen, a failure such as an oxygen-diffusion based failure may occur during subsequent thermal treatment steps which are performed as a part of the fabrication process. However, since the first sub-spacer SS1 is formed to have a sufficiently large thickness, the second region R2, in which the oxygen is not diffused, may be formed. The second region R2 may separate the bit line node contact DC from the oxygen, and thus, it may be possible to prevent or reduce the likelihood of such a failure, which may occur when the bit line node contact DC is in contact with the oxygen.

In some example embodiments, a capping spacer CS may cover a side surface of an upper portion of the bit line capping pattern BCP. The capping spacer CS may be further provided on at least a portion of a top surface of the bit line spacer SPC.

An intermediate material IM may be placed between the gapfill insulating pattern BI (e.g., the outer gapfill pattern Ba) and the device isolation pattern STI. In some example embodiments, the intermediate material IM may be further placed between the gapfill insulating pattern BI and the center oxide region Oc and/or between the gapfill insulating pattern BI and the edge oxide region Oe. As described herein, the expression "the intermediate material IM is positioned between elements A and B" should be understood to include that the intermediate material IM is positioned in an inner portion of the element B adjacent to the element A or is positioned in an inner portion of the element A adjacent to the element B. In some example embodiments, the intermediate material IM may be positioned along the inner surface of the first recess region RS1.

The intermediate material IM may include at least one of a halogen element and carbon. In some example embodiments, the intermediate material IM may be an unremoved portion or residue of a material, which is used to form the first sub-spacer SS1. In some example embodiments, the intermediate material IM may be a residue of an etcher, which will be described below, and may contain a halogen element such as at least one of fluorine, chlorine, bromine, or iodine. In some example embodiments, the intermediate material IM may be a residue of an inhibitor, which will be described below, and may contain carbon.

The storage node contact BC may be provided between adjacent ones of the bit lines BL. In some example embodiments, a plurality of storage node contacts BC may be provided, and the storage node contacts BC may be spaced apart from each other in the first and second directions D1 and D2. The storage node contact BC may be spaced apart from the bit line BL with the bit line spacer SPC interposed therebetween. The storage node contact BC may fill a second recess region RS2, which is formed on the edge portion EA of the active pattern ACT. The storage node contact BC may be electrically connected to the edge portion EA. In some example embodiments, the storage node contact BC may be in contact with the edge oxide region Oe and the edge non-oxide region NOe and may be electrically connected to the edge non-oxide region NOe.

The storage node contact BC may include a conductive material. In some example embodiments, the storage node contact BC may be formed of or include at least one of doped polysilicon or metallic materials (e.g., at least one of Ti, Mo, W, Cu, Al, Ta, Ru, Ir, Co, Pt, Au, and Ag).

On the word lines WL, fence patterns FN may separate the storage node contacts BC from each other in the second direction D2. In some example embodiments, the fence patterns FN may be spaced apart from each other in the second direction D2 with the storage node contacts BC interposed therebetween. In some example embodiments, the fence patterns FN may be formed of or include silicon nitride.

A diffusion barrier layer DP may conformally cover the storage node contact BC and the bit line spacer SPC. The diffusion barrier layer DP may be formed of or include a conductive metal nitride material (e.g., containing at least one of Ti, Mo, W, Cu, Al, Ta, Ru, Ir, Co, Pt, Au, or Ag). A metal silicide layer may be further interposed between the diffusion barrier layer DP and the storage node contact BC.

A landing pad LP may be provided on the storage node contact BC. In some example embodiments, a plurality of landing pads LP may be provided and may be spaced apart from each other in the first and second directions D1 and D2. Each of the landing pads LP may be connected to a corresponding one of the storage node contacts BC. The landing pad LP may cover a top surface of the bit line capping pattern BCP. In some example embodiments, a lower portion of the landing pad LP may be vertically overlapped with the storage node contact BC, and the upper portion of the landing pad LP may be shifted from the lower portion in the second direction D2 or an opposite direction thereof. The landing pad LP may be formed of or include at least one of metallic materials (e.g., one or more of Ti, Mo, W, Cu, Al, Ta, Ru, Ir, Co, Pt, Au, and Ag).

A filler pattern FI may be provided to enclose the landing pad LP. The filler pattern FI may be interposed between the landing pads LP, which are adjacent to each other. When viewed in a plan view, the filler pattern FI may be provided in a mesh shape with holes, and in this case, the landing pads LP may be provided in the holes to penetrate the filler pattern FI. In some example embodiments, the filler pattern FI may be formed of or include at least one of silicon nitride, silicon oxide, or silicon oxynitride. In some example embodiments, the filler pattern FI may include an empty space with an air layer (e.g., an air gap).

A data storage pattern DSP may be provided on the landing pad LP. In some example embodiments, a plurality of data storage patterns DSP may be provided. The data storage patterns DSP may be spaced apart from each other in the first and second directions D1 and D2. Each of the data storage patterns DSP may be electrically connected to a corresponding one of the edge portions EA of the active patterns ACT through a corresponding one of the landing pads LP and a corresponding one of the storage node contacts BC.

In some example embodiments, the data storage pattern DSP may be or may include a capacitor including a bottom electrode, a dielectric layer, and a top electrode. In this case, the semiconductor memory device according to some example embodiments of the inventive concept may be or may include or be included in a dynamic random access memory (DRAM) device. Alternatively or additionally, the data storage pattern DSP may include a magnetic tunnel junction pattern. In this case, the semiconductor memory device may be or may include or be included in a magnetic random access memory (MRAM) device. Alternatively or additionally, the data storage pattern DSP may be formed of or include a phase-change material and/or a variable resistance material. In this case, the semiconductor memory device may be or may include or be included in a phase-change random access memory (PRAM) device and/or a resistive random access memory (ReRAM) device. However, example embodiments are not limited to these examples, and the data storage pattern DSP may include various structures and/or materials which can be used to store data.

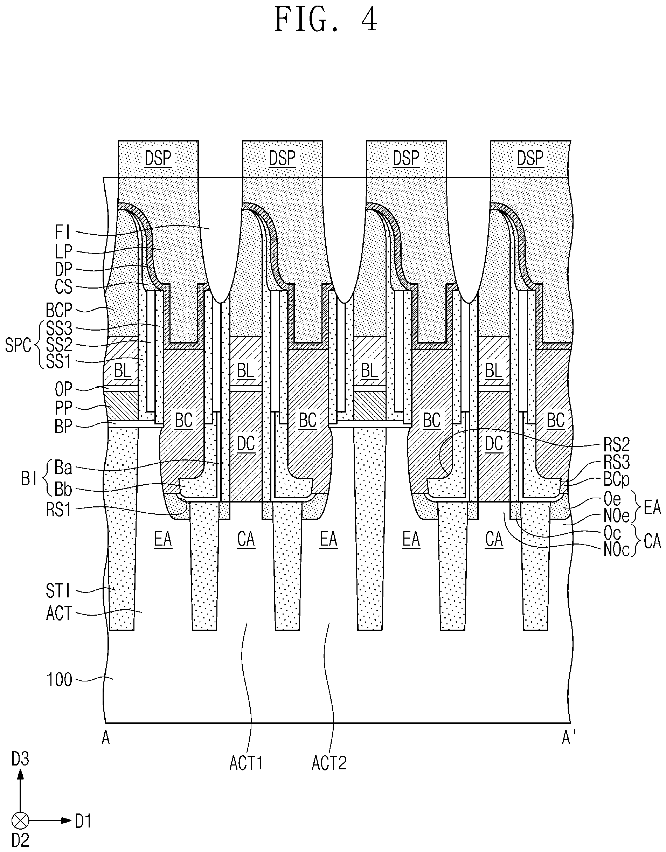

Hereinafter, some additional example embodiments will be described with reference to FIGS. 4 to 6. In the following description, a previously-described element may be identified by the same reference number without repeating an overlapping description thereof, for concise description.

FIGS. 4 to 6 are sectional views taken along the line A-A' of FIG. 1.

Referring to FIG. 4, a third recess region RS3 may be provided below the second recess region RS2. The third recess region RS3 may be connected to the second recess region RS2 and may have a width smaller than the second recess region RS2, when viewed in a sectional view. An inner surface of the second recess region RS2 and an inner surface of the third recess region RS3 may be connected to each other. The inner surface of the third recess region RS3 may be defined by the gapfill insulating pattern BI and the edge portion EA (e.g., the edge non-oxide region NOe) of the active pattern ACT.

The storage node contact BC may include a protruding portion BCp. The protruding portion BCp of the storage node contact BC may fill the third recess region RS3. The protruding portion BCp may protrude toward the edge oxide region Oe.

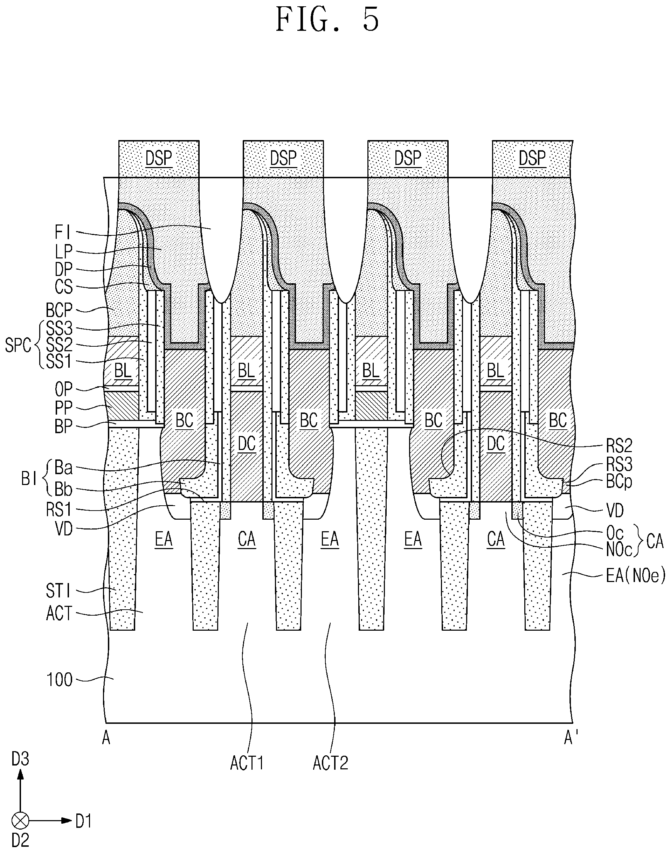

Referring to FIG. 5, the edge oxide region Oe may not be provided. The third recess region RS3 may extend to an upper portion of the device isolation pattern STI to expose a side surface of the upper portion of the device isolation pattern STI. The protruding portion BCp of the storage node contact BC may fill an upper portion of the third recess region RS3. A lower portion of the third recess region RS3 may include an empty space (e.g., a void VD) that may or may not be under vacuum.

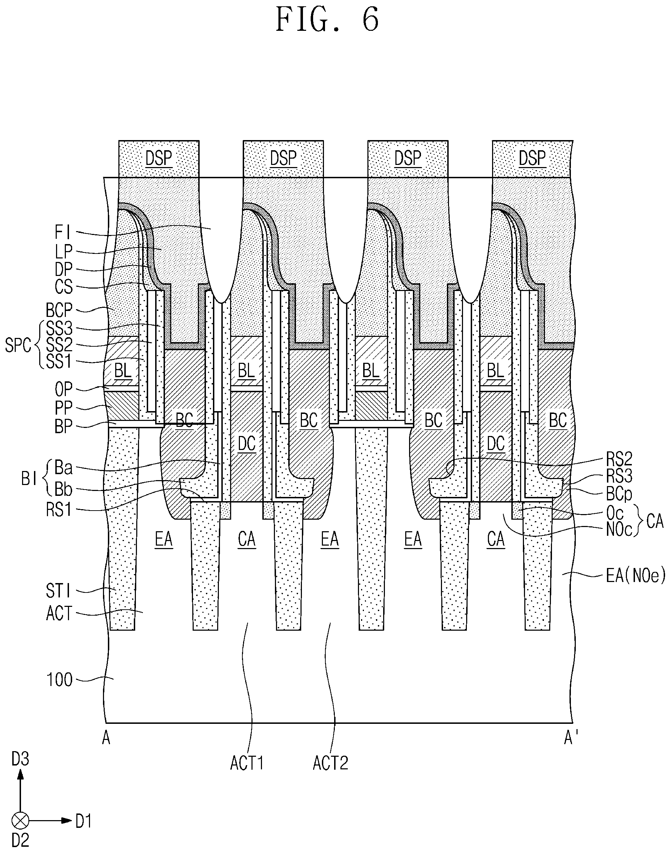

Referring to FIG. 6, the edge oxide region Oe may not be provided, as shown in FIG. 5. However, the protruding portion BCp of the storage node contact BC may be provided to fully fill the third recess region RS3, unlike the structure of FIG. 5. Accordingly, the void VD may not be provided in the third recess region RS3.

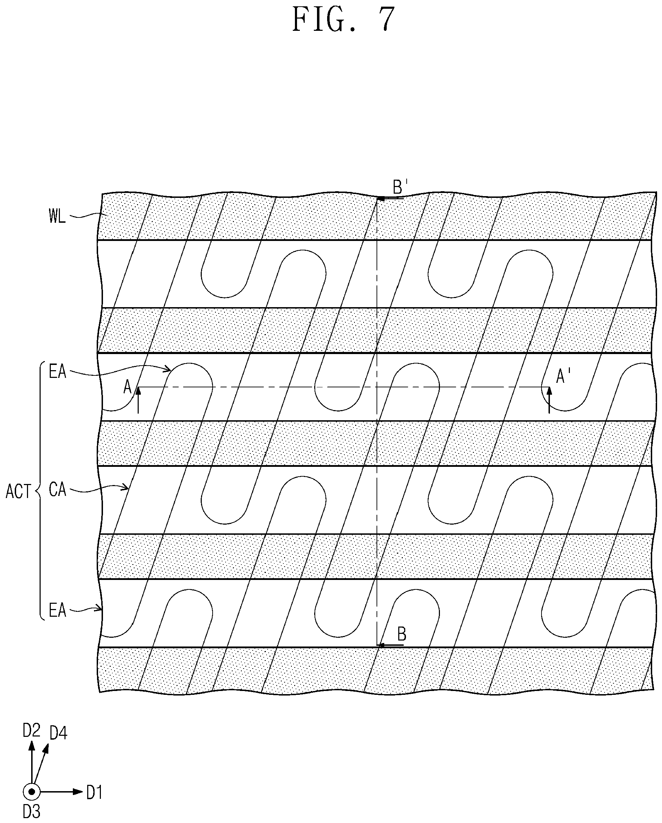

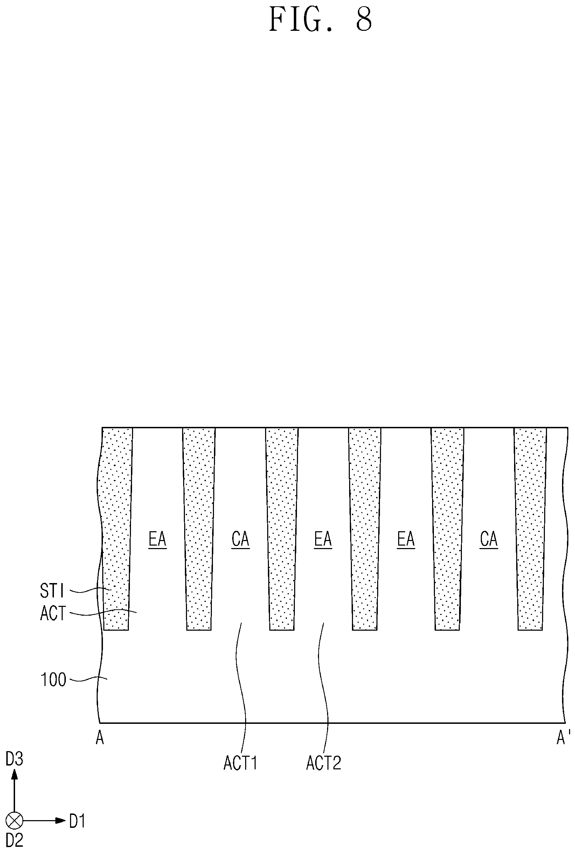

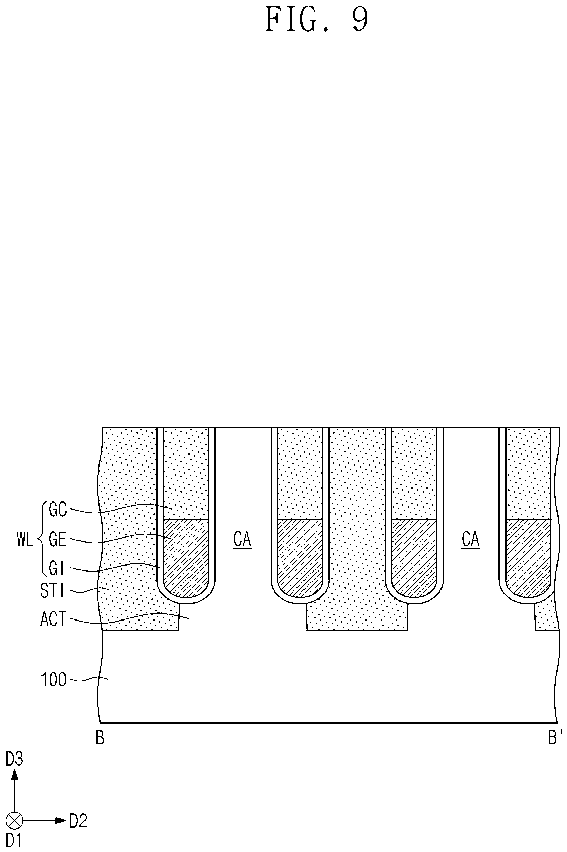

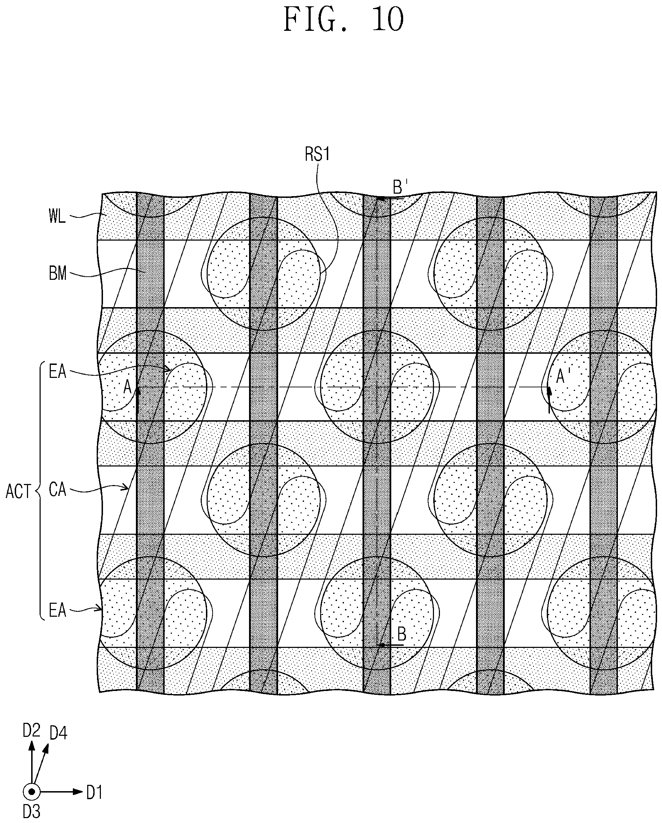

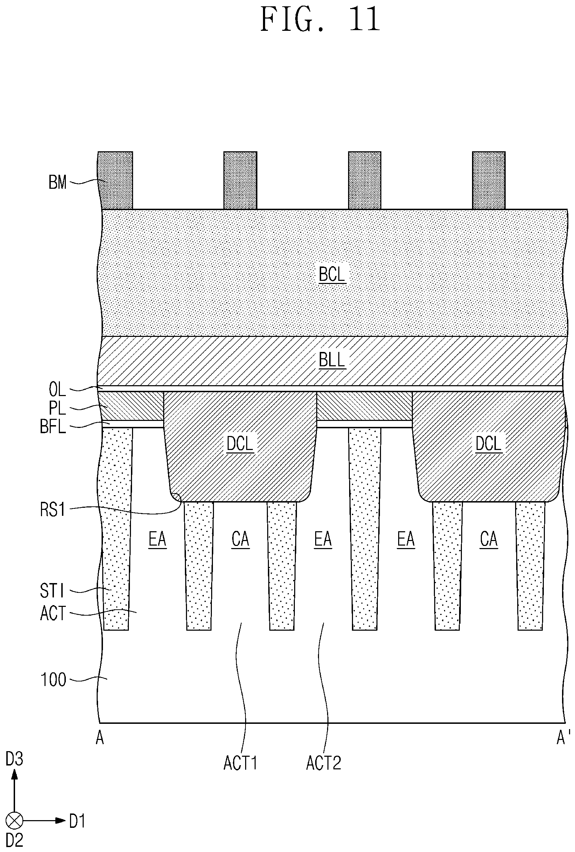

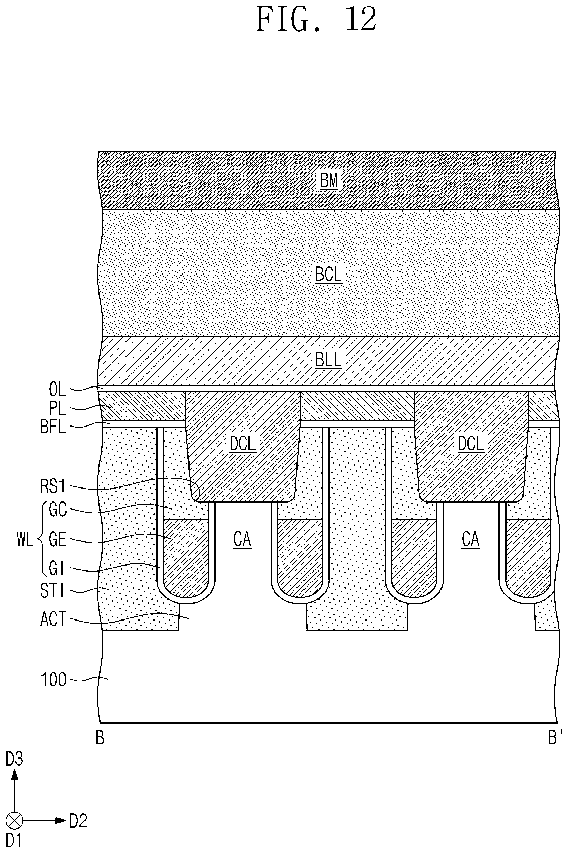

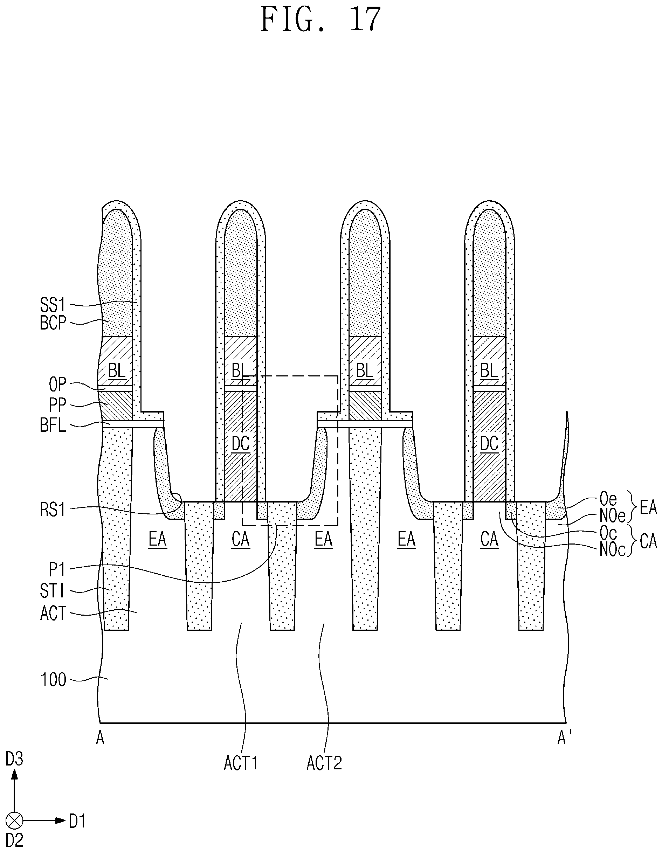

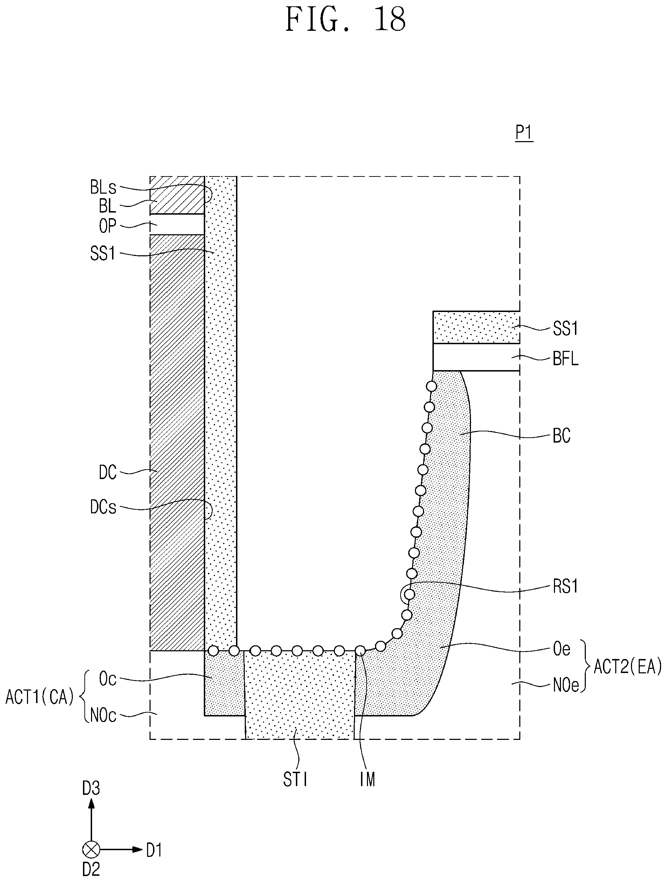

FIGS. 7 to 22 are diagrams illustrating a method of fabricating a semiconductor device, according to various example embodiments More specifically, FIGS. 7, 10, 13, 16, and 20 are sectional plan views illustrating a method of fabricating a semiconductor device, according to various example embodiments FIGS. 8, 11, 14, 15, 17, 19, 21, and 22 are sectional views taken along lines A-A' of FIGS. 7, 10, 13, 16, and 20, respectively. FIGS. 9 and 12 are sectional views taken along lines B-B' of FIGS. 7 and 10. FIG. 18 is an enlarged view illustrating a portion 'P1' of FIG. 17. Hereinafter, the fabrication method according to some example embodiments of the inventive concept will be described in more detail with reference to FIGS. 7 to 22.

Referring to FIGS. 7 to 9, the substrate 100 may be prepared. The device isolation pattern STI and the active patterns ACT may be formed on the substrate 100. The formation of the device isolation pattern STI and the active patterns ACT may include performing a patterning process to form a trench region in the substrate 100 and filling the trench region with an insulating material to form the device isolation pattern STI. The active patterns ACT may be a portion of the substrate 100, in which the trench region is not formed.

The word lines WL may be formed to cross the active patterns ACT and the device isolation pattern STI in the first direction D1. The formation of the word lines WL may include forming mask patterns on the active patterns ACT and the device isolation pattern STI, performing an anisotropic etching process using the mask patterns to form trench regions, and filling the trench regions with the word lines WL. The word lines WL may be spaced apart from each other in the second direction D2.

The paired word lines WL may be provided to cross the active pattern ACT, and the center portion CA of the active pattern ACT may be defined between the paired word lines WL. Opposite portions of the active pattern ACT, which are spaced apart from the center portion CA with each of the paired word lines WL interposed therebetween, may be defined as the edge portions EA.

Referring to FIGS. 10 to 12, a buffer layer BFL and a polysilicon layer PL may be formed on the device isolation pattern STI and the active patterns ACT. Next, the first recess region RS1 may be formed on the center portion CA of the active pattern ACT. As a result of the formation of the first recess region RS1, an upper portion of the device isolation pattern STI, an upper portion of the center portion CA of the active pattern ACT, and an upper portion of the edge portion EA of the active pattern ACT may be recessed. The first recess region RS1 may vertically overlap with the center and edge portions CA and EA of the active pattern ACT. In some example embodiments, the first recess region RS1 may vertically overlap with a portion of the edge portion EA of the active pattern ACT. The first recess region RS1 may be provided to expose the device isolation pattern STI and the center and edge portions CA and EA of the active pattern ACT. The formation of the first recess region RS1 may include performing an etching such as an etching including an anisotropic etching process on the polysilicon layer PL, the buffer layer BFL, the device isolation pattern STI, and the active pattern ACT.

The preliminary bit line node contact DCL may be formed to fill the first recess region RS1. The preliminary bit line node contact DCL may be formed to cover the center portions CA of the active patterns ACT. In some example embodiments, a top surface of the preliminary bit line node contact DCL and a top surface of the polysilicon layer PL may be formed at substantially the same height and may be substantially coplanar with each other. Next, an ohmic layer OL, a bit line layer BLL, a bit line capping layer BCL, and a bit line mask pattern BM may be sequentially stacked on the preliminary bit line node contact DCL.

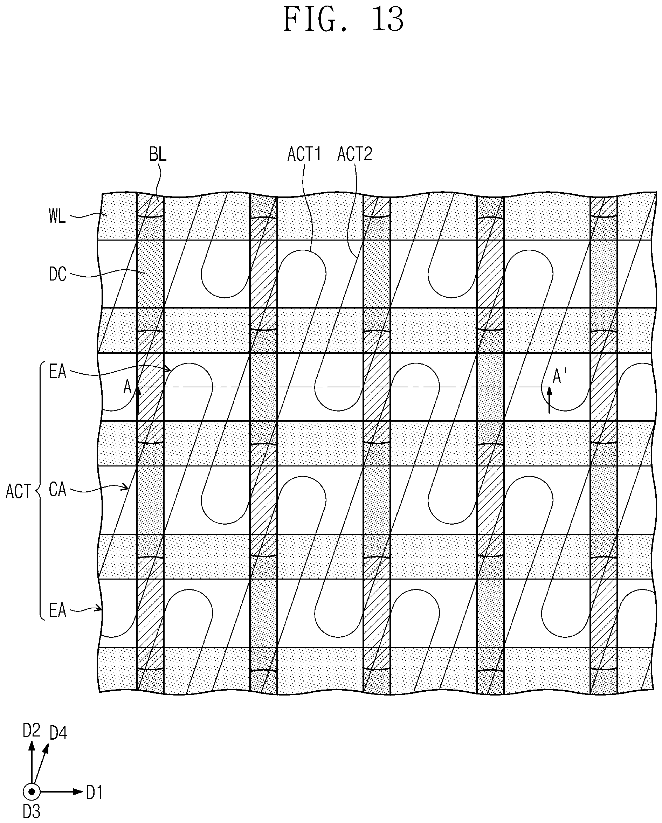

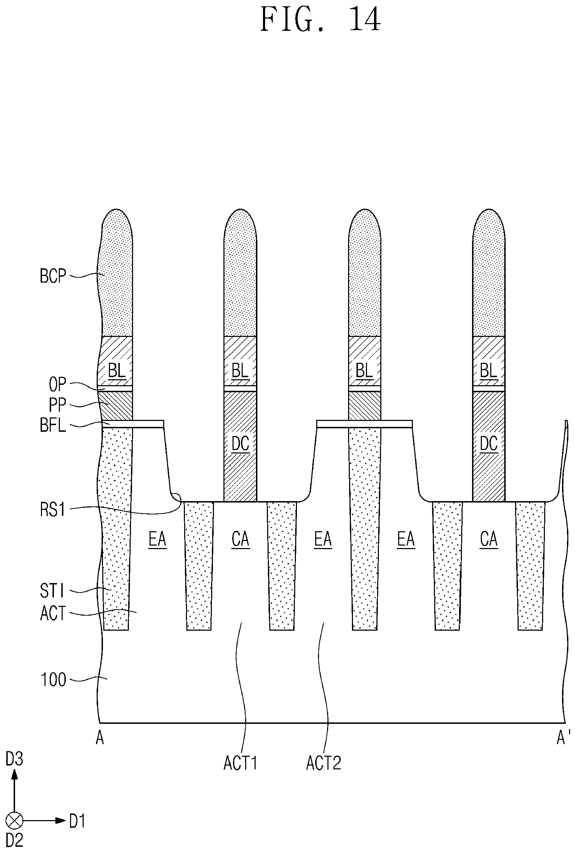

Referring to FIGS. 13 and 14, an anisotropic etching process, such as a dry etching process, may be performed using the bit line mask pattern BM as an etch mask. The preliminary bit line node contact DCL, the polysilicon layer PL, the ohmic layer OL, the bit line layer BLL, and the bit line capping layer BCL may be etched by the anisotropic etching process to form the bit line node contact DC, the polysilicon pattern PP, the ohmic pattern OP, the bit line BL, and the bit line capping pattern BCP. During this process, the inner surface of the first recess region RS1 and the buffer layer BFL may be exposed to the outside. In some example embodiments, the center and edge portions CA and EA of the active pattern ACT may be partially exposed through the inner surface of the first recess region RS1.

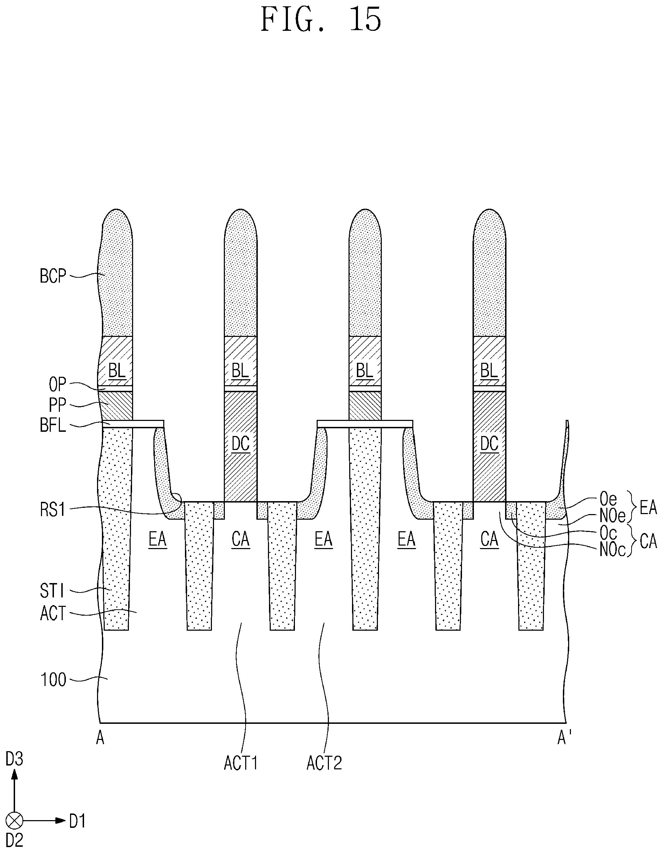

Referring to FIG. 15, an oxidation process may be performed on the exposed portions of the center and edge portions CA and EA of the active pattern ACT. The center oxide region Oc of the center portion CA and the edge oxide region Oe of the edge portion EA may be formed as a result of the oxidation process. An un-oxidized region of the center portion CA may be defined as the center non-oxide region NOc, and an un-oxidized region of the edge portion EA may be defined as the edge non-oxide region NOe.

The oxidation process may occur sparsely or hardly on the side surface BLs of the bit line BL and the side surface DCs of the bit line node contact DC. For this, the oxidation process may include performing an anisotropic oxidation process in the third direction D3. In some example embodiments, the anisotropic oxidation process may include performing an anisotropic plasma oxidation process in the third direction D3. In some example embodiments, the anisotropic oxidation process may include an oxide deposition process in the third direction D3. In some example embodiments, the anisotropic oxidation process may include a beam line process (e.g., an ion implantation process) in the third direction D3. However, example embodiments are not limited thereto, and the oxidation process may be performed in various manners. For example, alternatively or additionally the oxidation process may be or may include a thermal oxidation process; example embodiments are not limited thereto. In some example embodiments, during the oxidation process the center portion CA and the edge portion EA may be partially oxidized, e.g., single-crystal silicon may be replaced with silicon oxide; example embodiments are not limited thereto. There may or may not be steam included during the oxidation process.

In some example embodiments, a removal process (e.g., an isotropic etching process) may be further performed to remove a small amount of an oxide layer, which is formed on the side surface BLs of the bit line BL and the side surface DCs of the bit line node contact DC. Both of the center and edge oxide regions Oc and Oe may be left, even after the removal of the small amount of the oxide layer.

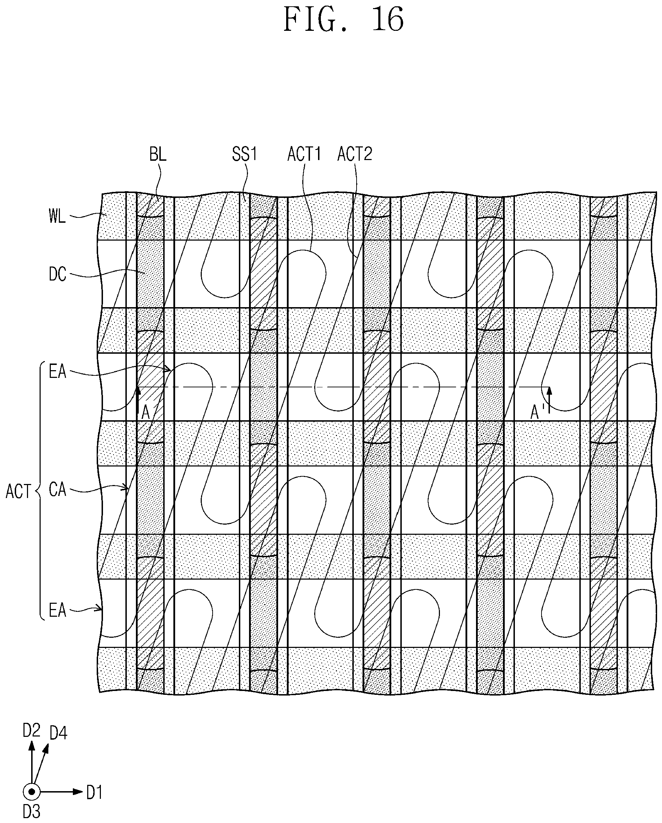

Referring to FIGS. 16 to 18, the first sub-spacer SS1 may be formed on the side surface BLs of the bit line BL and the side surface DCs of the bit line node contact DC. In some example embodiments, the first sub-spacer SS1 may selectively formed. In some example embodiments, owing to the oxygen in the center oxide region Oc, the edge oxide region Oe, and the device isolation pattern STI, these portions may not have the first sub-spacer SS1 formed therein. For example, the first sub-spacer SS1 may be formed on the side surface BLs of the bit line BL and the side surface DCs of the bit line node contact DC but may be formed to have a little or small presence on the center oxide region Oc, the edge oxide region Oe, and the device isolation pattern STI. Thus, after the formation of the first sub-spacer SS1, the center and edge oxide regions Oc and Oe may be exposed to the outside. The first sub-spacer SS1 may be further formed even on the buffer layer BFL, but example embodiments are not limited thereto.

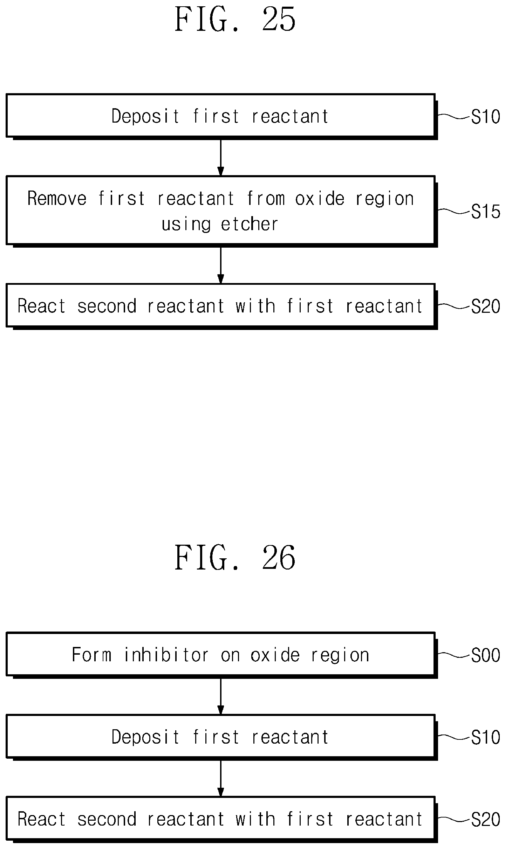

After the formation of the first sub-spacer SS1, the intermediate material IM may be left along the inner surface of the first recess region RS1. In some example embodiments, the intermediate material IM may be or may include an unremoved portion or residue of a material, which is used to form the first sub-spacer SS 1. (See FIGS. 25 and 26).

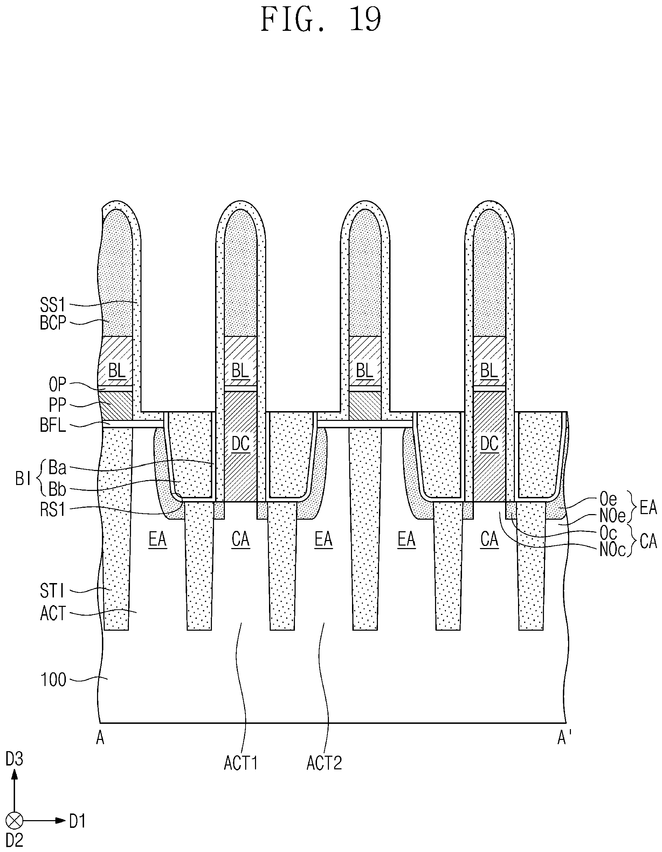

Referring to FIG. 19, the gapfill insulating pattern BI may be formed in the first recess region RS1. The gapfill insulating pattern BI may be formed to fill the first recess region RS1. The formation of the gapfill insulating pattern BI may include forming the outer gapfill pattern Ba on the substrate 100, forming the inner gapfill pattern Bb to cover the outer gapfill pattern Ba and fill the first recess region RS1, and removing the outer gapfill pattern Ba and the inner gapfill pattern Bb from a region higher than the first recess region RS1.

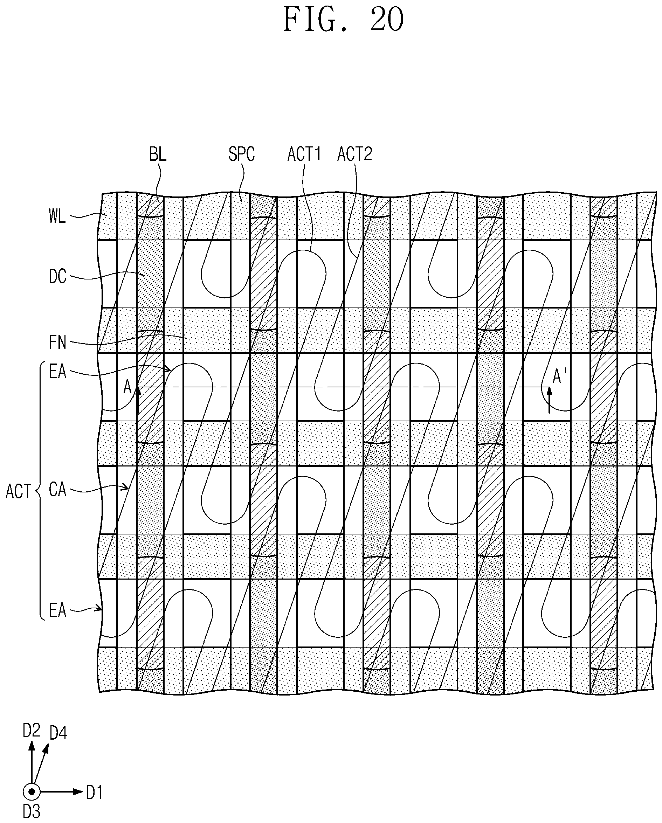

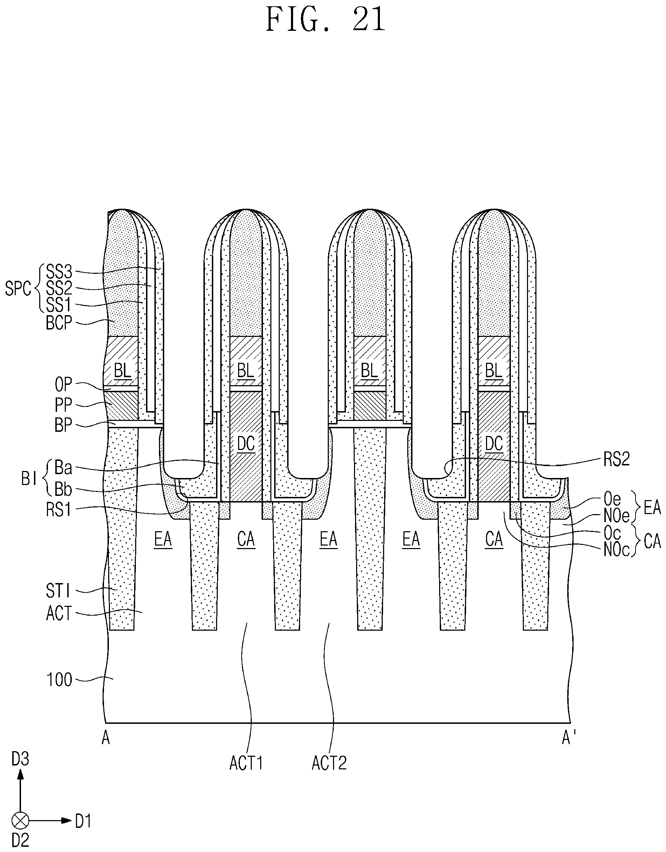

Referring to FIGS. 20 and 21, the second and third sub-spacers SS2 and SS3 may be formed on the side surface BLs of the bit line BL. The second and third sub-spacers SS2 and SS3 may be sequentially formed. The second recess region RS2 may be formed by performing an etching process using the bit line capping pattern BCP as an etch mask. The second recess region RS2 may be formed to expose the gapfill insulating pattern BI and the edge oxide region Oe. Since the first sub-spacer SS1 is selectively formed in the previous step, it may be possible to easily or more easily form the second recess region RS2 exposing the edge oxide region Oe.

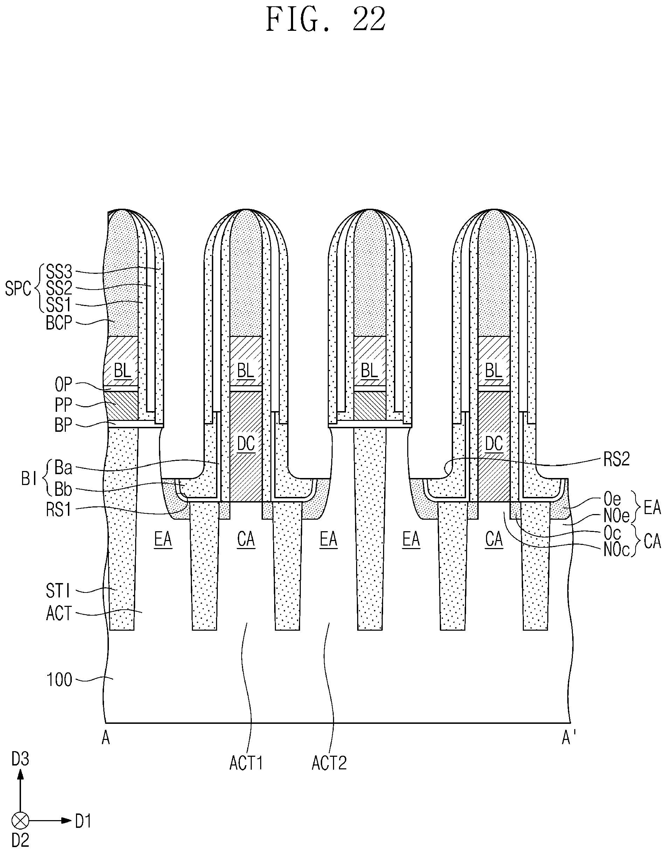

Referring to FIG. 22, a removal process may be performed on the edge oxide region Oe exposed through the second recess region RS2. The removal process may include a wet etching process such as a buffered hydrogen-fluoride wet etching process; however, example embodiments are not limited thereto. As a result, the edge non-oxide region NOe may be exposed through the second recess region RS2.

Referring back to FIGS. 1 to 2B, the storage node contact BC and the fence pattern FN may be formed. The storage node contact BC may be formed to fill the second recess region RS2. In the second recess region RS2, the storage node contact BC may be electrically connected to the edge portion EA of the active pattern ACT through the edge non-oxide region NOe.

The fence pattern FN may be formed before or after the formation of the storage node contact BC. In some example embodiments, the fence pattern FN may be formed between the storage node contacts BC, after the formation of the storage node contact BC. The fence pattern FN may be formed before the formation of the second recess region RS2, and the storage node contact BC may be formed between the fence patterns FN.

The landing pads LP may be formed on the storage node contacts BC. The formation of the landing pads LP may include sequentially forming a landing pad layer (not shown) and mask patterns (not shown) to cover the top surfaces of the storage node contacts BC and performing an anisotropic etching process using the mask patterns as an etch mask to divide the landing pad layer into a plurality of landing pads LP.

Next, the filler pattern FI may be formed in a region that is formed by removing the landing pad layer. The filler pattern FI may be formed to enclose each of the landing pads LP. The data storage pattern DSP may be formed on each of the landing pads LP.

According to some example embodiments, since the first sub-spacer SS1 is selectively formed, the edge oxide region Oe may be easily or more easily exposed, and as a result, it may be easy or easier to electrically connect the storage node contact BC to the edge non-oxide region NOe. Alternatively or additionally, the first sub-spacer SS1 is formed to have a sufficiently large thickness on the side surface DCs of the bit line node contact DC, the bit line node contact DC may be separated from oxygen, and thus, it may be possible to prevent or reduce the likelihood of a failure which may occur when the bit line node contact DC is in contact with the oxygen. As a result, it may be possible to reduce a failure of the semiconductor device, and the electrical and/or reliability characteristics of the semiconductor device may be improved. For example, a yield may increase.

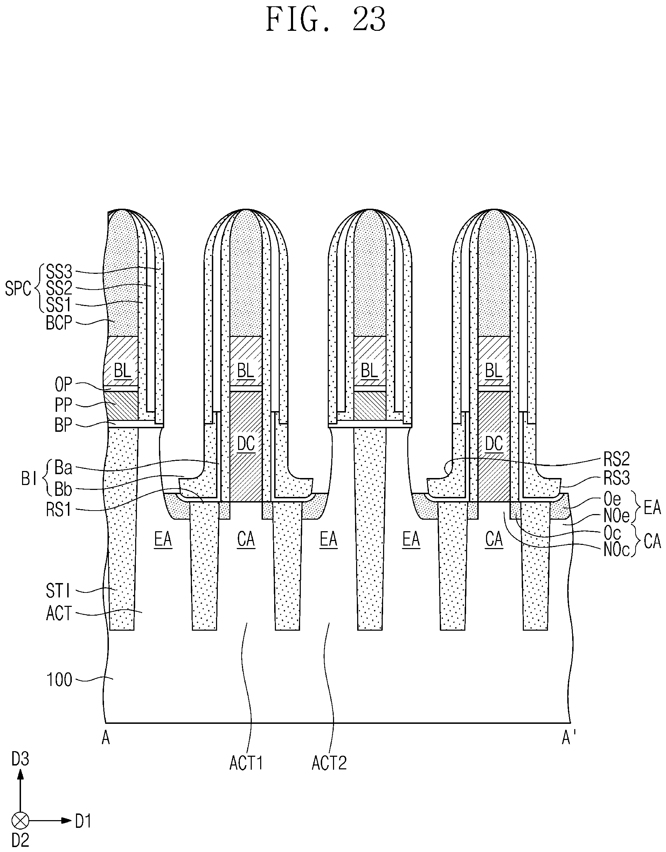

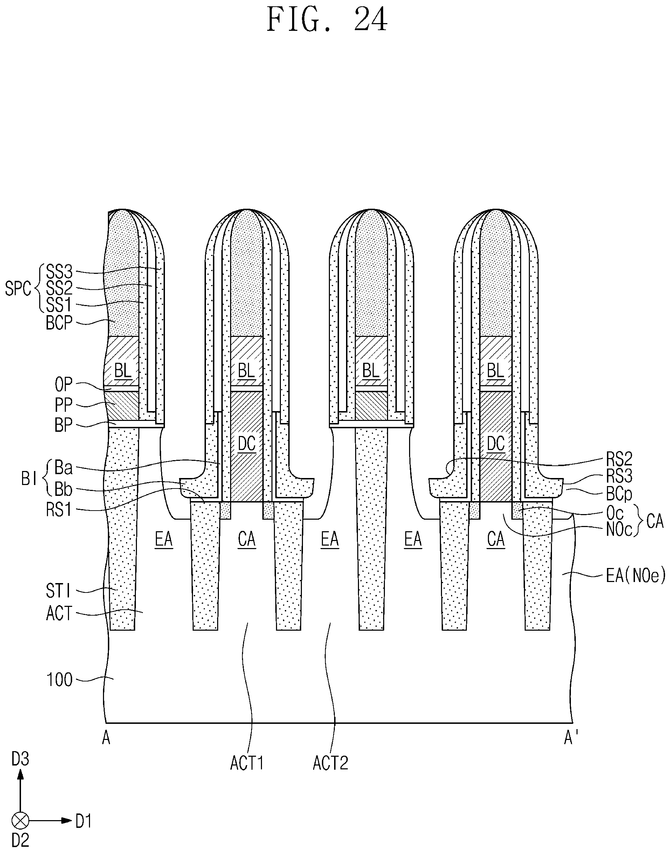

FIGS. 23 and 24 are sectional views illustrating a method of fabricating a semiconductor device, according to various example embodiments

Referring to FIG. 23, a removal process may be performed on the edge oxide region Oe exposed by the second recess region RS2. The third recess region RS3 may be further formed in the region, which is formed by removing the edge oxide region Oe. Thus, the storage node contact BC may be formed in a subsequent process to fill the second recess region RS2 and the third recess region RS3, and the semiconductor device may be formed to have the final structure shown in FIG. 4.

Referring to FIG. 24, the edge oxide region Oe, which is exposed by the second recess region RS2, may be completely removed. Thus, the third recess region RS3 may extend to an upper portion of the device isolation pattern STI to expose a side surface of the upper portion of the device isolation pattern STI. In some example embodiments, the storage node contact BC may fill a portion of the third recess region RS3 in a subsequent process, and in this case, the semiconductor device may be formed to have the structure shown in FIG. 5. In some example embodiments, the storage node contact BC may fill the entirety of the third recess region RS3 in a subsequent process, and in this case, the semiconductor device may be formed to have the structure shown in FIG. 6.

FIGS. 25 and 26 are flow charts illustrating a method of fabricating a first sub-spacer.

Referring to FIG. 25, the selective formation of the first sub-spacer SS1 may include depositing a first reactant (in S10), removing the first reactant from the center and edge oxide regions Oc and Oe using an etcher (S15), and reacting a second reactant with a remaining portion of the first reactant (in S20). In some example embodiments, the steps S10, S15, and S20 may be alternately and repeatedly performed to selectively form the first sub-spacer SS1.

The deposition of the first reactant (in S10) may include selectively depositing the first reactant. The first reactant may include a precursor (e.g., including silicon (Si)). In some example embodiments, the precursor may further include a halogen element. As an example, the precursor may include at least one of DCS (SiH₂Cl₂), TCS (SiCl₄), or DIS (SiH₂I₂), but example embodiments are not limited thereto. The precursor may include a material with deposition selectivity. As an example, the precursor may be relatively more deposited on the side surface BLs of the bit line BL and the side surface DCs of the bit line node contact DC and may be sparsely or hardly on the center and edge oxide regions Oc and Oe containing an oxide material. For example, the first reactant may be selectively deposited on the side surface BLs of the bit line BL and the side surface DCs of the bit line node contact DC.

The center and edge oxide regions Oc and Oe may be exposed through the removing of the first reactant from the center and edge oxide regions Oc and Oe using the etcher (in S15). Even when the removal process (S15) is performed, the first reactant may be left on the side surface BLs of the bit line BL and the side surface DCs of the bit line node contact DC. The etcher may include a halogen element. As an example, the etcher may include a gas containing at least one of halogen elements (e.g., F and Cl).

The reaction between the first and second reactants (in S20) may include reacting the second reactant with the first reactant, which is positioned on the side surface BLs of the bit line BL and the side surface DCs of the bit line node contact DC. On the center and edge oxide regions Oc and Oe, the reaction between the first and second reactants may be suppressed, because the reaction of the first reactant is suppressed by the etcher. As a result of the reaction between the first and second reactants, the first sub-spacer SS1 may be formed. As a result, by forming the first reactant on the side surface BLs of the bit line BL and the side surface DCs of the bit line node contact DC and removing the first reactant from the center and edge oxide regions Oc and Oe, it may be possible to selectively form the first sub-spacer SS1. In some example embodiments, the second reactant may include NH₃, but example embodiments are not limited thereto.

A portion of the etcher may be left along the inner surface of the first recess region RS1, even after the formation of the first sub-spacer SS1, and may be positioned between the gapfill insulating pattern BI and the device isolation pattern STI in a subsequent process. In this case, the intermediate material IM may contain a portion of the etcher, and, in some example embodiments, it may contain a halogen element.

Referring to FIG. 26, the selective formation of the first sub-spacer SS1 may include forming an inhibitor on the center and edge oxide regions Oc and Oe (in S00), depositing a first reactant (in S10), and reacting a second reactant with the first reactant (in S20). In some example embodiments, the steps 500, S10, and S20 may be alternately and repeatedly performed to selectively form the first sub-spacer SS1.

In some example embodiments, the forming of the inhibitor on the center and edge oxide regions Oc and Oe (in S00) may include selectively forming the inhibitor on the center and edge oxide regions Oc and Oe. As an example, the inhibitor may be selectively formed on the center and edge oxide regions Oc and Oe containing an oxide material but may be formed to have a little or small presence on the side surface BLs of the bit line BL and the side surface DCs of the bit line node contact DC. In some example embodiments, the inhibitor may contain carbon.

The deposition of the first reactant (in S10) may include selectively depositing the first reactant. Due to the presence of the inhibitor, the first reactant may be deposited sparsely or hardly on the center and edge oxide regions Oc and Oe. Thus, the first reactant may be selectively deposited on the side surface BLs of the bit line BL and the side surface DCs of the bit line node contact DC.

The reaction of the first and second reactants (in S20) may include reacting the second reactant with the first reactant on the side surface BLs of the bit line BL and the side surface DCs of the bit line node contact DC. Since, on the center and edge oxide regions Oc and Oe, the inhibitor suppresses the deposition of the first reactant, the reaction between the first and second reactants may be inhibited. As a result, the first sub-spacer SS1 may be selectively formed on the side surface BLs of the bit line BL and the side surface DCs of the bit line node contact DC.

After the formation of the first sub-spacer SS1, the inhibitor may be partially left on the inner surface of the first recess region RS1 and may be positioned between the gapfill insulating pattern BI and the device isolation pattern STI during a subsequent process. In this case, the intermediate material IM may contain a portion of the inhibitor (e.g., carbon) in the final stage.

However, FIGS. 25 and 26 illustrate an example of various methods for forming the first sub-spacer SS1. For example, if the deposition selectivity of the first reactant is good, the first sub-spacer SS1 may be selectively formed using the deposition of the first reactant (in S10) and the reaction of the first and second reactants (in S20), without using the etcher or the inhibitor. In some example embodiments, both of the etcher and the inhibitor may be used; for example, the steps of forming the inhibitor (in S00), depositing the first reactant (in S10), removing the first reactant using the etcher (S15), and reacting the first and second reactants (in S20) may be sequentially performed.

According to some example embodiments of the inventive concept, a first sub-spacer may be selectively formed. This may make it possible to easily or more easily connect a storage node contact to an edge portion of an active pattern and to prevent a failure, which may occur when a bit line node contact is in contact with oxygen. As a result, it may be possible to reduce a failure in a semiconductor device, and the electrical and/or reliability characteristics of the semiconductor device may be improved.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Moreover, when the words "generally" and "substantially" are used in connection with material composition, it is intended that exactitude of the material is not required but that latitude for the material is within the scope of the disclosure.

Further, regardless of whether numerical values or shapes are modified as "about" or "substantially," it will be understood that these values and shapes should be construed as including a manufacturing or operational tolerance (e.g., ±10%) around the stated numerical values or shapes. Thus, while the term "same," "identical," or "equal" is used in description of example embodiments, it should be understood that some imprecisions may exist. Thus, when one element or one numerical value is referred to as being the same as another element or equal to another numerical value, it should be understood that an element or a numerical value is the same as another element or another numerical value within a desired manufacturing or operational tolerance range (e.g., ±10%).

While various example embodiments of the inventive concept have been particularly shown and described, it will be understood by one of ordinary skill in the art that variations in form and detail may be made therein without departing from the spirit and scope of the attached claims. Additionally, example embodiments are not necessarily mutually exclusive with one another. For example, some example embodiments may include one or more features described with reference to one or more figures, and may also include one or more other features described with reference to one or more other figures.

## Claims

1. A semiconductor device, comprising:
first and second active patterns, each including a center portion and an edge portion, the center portion of the first active pattern and the edge portion of the second active pattern adjacent to each other;
a device isolation pattern between the first and second active patterns;
a bit line node contact on the center portion of the first active pattern;
a bit line on the bit line node contact;
a storage node contact on the edge portion of the second active pattern;
a bit line spacer between the bit line and the storage node contact; and
a gapfill insulating pattern between a lower portion of the bit line spacer and the storage node contact,
wherein the center portion of the first active pattern comprises a center oxide region provided in an upper portion thereof.

2. The semiconductor device of claim 1, wherein the bit line spacer covers a side surface of the bit line and extends to a side surface of the bit line node contact.

3. The semiconductor device of claim 1, wherein
the bit line spacer comprises a first sub-spacer and a second sub-spacer sequentially provided on a side surface of the bit line, and
the first sub-spacer is spaced apart from the storage node contact.

4. The semiconductor device of claim 3, wherein the first sub-spacer comprises:
a first region adjacent to the second sub-spacer; and
a second region separating the first region from the bit line,
wherein the first region contains oxygen and nitrogen.

5. The semiconductor device of claim 1, further comprising:
an intermediate material between the gapfill insulating pattern and the device isolation pattern,
wherein the intermediate material comprises at least one of a halogen element and carbon.

6. The semiconductor device of claim 1, wherein the gapfill insulating pattern is spaced apart from the bit line node contact and is in contact with the device isolation pattern.

7. The semiconductor device of claim 1, wherein the gapfill insulating pattern vertically and partially overlaps the edge portion of the second active pattern.

8. The semiconductor device of claim 1, wherein
the gapfill insulating pattern comprises an outer gapfill pattern in contact with the device isolation pattern, and
the outer gapfill pattern contains oxygen.

9. The semiconductor device of claim 1, wherein the gapfill insulating pattern separates the lower portion of the bit line spacer from the storage node contact.

10. The semiconductor device of claim 1, wherein the center oxide region comprises a pair of center oxide regions spaced apart from each other in a first direction.

11. The semiconductor device of claim 1, wherein the edge portion of the second active pattern comprises an edge oxide region in contact with the gapfill insulating pattern.

12. The semiconductor device of claim 11, wherein the edge oxide region is in contact with the storage node contact.

13. A method of fabricating a semiconductor device, comprising:
forming a recess region on a center portion of a first active pattern and an edge portion of a second active pattern, the first and second active patterns adjacent to each other, the recess region exposing a portion of the edge portion of the second active pattern;
forming a bit line node contact on the center portion of the first active pattern;
forming a bit line on the bit line node contact;
oxidizing the exposed portion of the edge portion of the second active pattern to form an edge oxide region;
selectively forming a sub-spacer on a side surface of the bit line node contact and a side surface of the bit line; and
forming a gapfill insulating pattern to fill the recess region.

14. The method of claim 13, wherein the selective forming of the sub-spacer comprises:
depositing a first reactant on the side surface of the bit line node contact, the side surface of the bit line, and the edge oxide region;
removing the first reactant on the edge oxide region using an etcher; and
reacting the first reactant left on the side surface of the bit line node contact and the side surface of the bit line with a second reactant to form a sub-spacer.

15. The method of claim 13, wherein the selective forming of the sub-spacer comprises:
forming an inhibitor on the edge oxide region;
depositing a first reactant on the side surface of the bit line node contact and the side surface of the bit line; and
reacting the first reactant with a second reactant to form a sub-spacer,
wherein the depositing of the first reactant is suppressed on the edge oxide region by the inhibitor.

## Amended claims

### Amended claims in accordance with Rule 137(2) EPC.

1. A semiconductor device, comprising:
first and second active patterns (ACT1, ACT2), each including a center portion (CA) and an edge portion (EA), the center portion (CA) of the first active pattern (ACT1) and the edge portion (EA) of the second active pattern (ACT2) adjacent to each other;
a device isolation pattern (STI) between the first and second active patterns (ACT2);
a bit line node contact (DC) on the center portion (CA) of the first active pattern (ACT1);
a bit line (BL) on the bit line node contact (DC);
a storage node contact (BC) on the edge portion (EA) of the second active pattern (ACT2);
a bit line spacer (SPC) between the bit line (BL) and the storage node contact (BC); and
a gapfill insulating pattern (BI) between a lower portion of the bit line spacer (SPC) and the storage node contact (BC),
wherein the center portion (CA) of the first active pattern (ACT1) comprises a center oxide region (Oc) provided in an upper portion thereof, and
wherein the edge portion (EA) of the second active pattern (ACT2) comprises an edge oxide region (Oe) in contact with the gapfill insulating pattern (BI).

2. The semiconductor device of claim 1, wherein the bit line spacer (SPC) covers a side surface of the bit line (BL) and extends to a side surface of the bit line node contact (DC).

3. The semiconductor device of claim 1, wherein
the bit line spacer (SPC) comprises a first sub-spacer (SS1) and a second sub-spacer (SS2) sequentially provided on a side surface of the bit line (BL), and
the first sub-spacer (SS1) is spaced apart from the storage node contact (BC).

4. The semiconductor device of claim 3, wherein the first sub-spacer (SS1) comprises:
a first region (R1) adjacent to the second sub-spacer (SS2); and
a second region (R2) separating the first region (R1) from the bit line (BL),
wherein the first region (R1) contains oxygen and nitrogen.

5. The semiconductor device of claim 1, further comprising:
an intermediate material (IM) between the gapfill insulating pattern (BI) and the device isolation pattern (STI),
wherein the intermediate material (IM) comprises at least one of a halogen element and carbon.

6. The semiconductor device of claim 1, wherein the gapfill insulating pattern (BI) is spaced apart from the bit line node contact (DC) and is in contact with the device isolation pattern (STI).

7. The semiconductor device of claim 1, wherein the gapfill insulating pattern (BI) vertically and partially overlaps the edge portion (EA) of the second active pattern (ACT2).

8. The semiconductor device of claim 1, wherein
the gapfill insulating pattern (BI) comprises an outer gapfill pattern (Ba) in contact with the device isolation pattern (STI), and
the outer gapfill pattern (Ba) contains oxygen.

9. The semiconductor device of claim 1, wherein the gapfill insulating pattern (BI) separates the lower portion of the bit line spacer (SPC) from the storage node contact (BC).

10. The semiconductor device of claim 1, wherein the center oxide region (Oc) comprises a pair of center oxide regions (Oc) spaced apart from each other in a first direction (D1).

11. The semiconductor device of claim 1, wherein the edge oxide region (Oe) is in contact with the storage node contact (BC).

12. A method of fabricating a semiconductor device, comprising:
forming a recess region on a center portion (CA) of a first active pattern (ACT1) and an edge portion (EA) of a second active pattern (ACT2), the first and second active patterns (ACT1, ACT2) adjacent to each other, the recess region exposing a portion of the edge portion (EA) of the second active pattern (ACT2);
forming a bit line node contact (DC) on the center portion (CA) of the first active pattern (ACT1);
forming a bit line (BL) on the bit line node contact (DC);
oxidizing the exposed portion of the edge portion (EA) of the second active pattern (ACT2) to form an edge oxide region (Oe);
selectively forming a sub-spacer on a side surface of the bit line node contact (DC) and a side surface of the bit line (BL); and
forming a gapfill insulating pattern (BI) to fill the recess region.

13. The method of claim 12, wherein the selective forming of the sub-spacer comprises:
depositing (S10) a first reactant on the side surface of the bit line node contact (DC), the side surface of the bit line (BL), and the edge oxide region (Oe);
removing (S15) the first reactant on the edge oxide region (Oe) using an etcher; and
reacting (S20) the first reactant left on the side surface of the bit line node contact (DC) and the side surface of the bit line (BL) with a second reactant to form a sub-spacer.

14. The method of claim 12, wherein the selective forming of the sub-spacer comprises:
forming (S00) an inhibitor on the edge oxide region (Oe);
depositing (S10) a first reactant on the side surface of the bit line node contact (DC) and the side surface of the bit line (BL); and
reacting (S20) the first reactant with a second reactant to form a sub-spacer,
wherein the depositing of the first reactant is suppressed on the edge oxide region (Oe) by the inhibitor.
